(19) **Europäisches Patentamt / European Patent Office / Office européen des brevets**

(11) **EP 2 647 120 B1**

(12) **FASCICULE DE BREVET EUROPEEN**

(45) Date de publication et mention de la délivrance du brevet:
**29.04.2015 Bulletin 2015/18**

(21) Numéro de dépôt: **11788825.5**

(22) Date de dépôt: **28.11.2011**

(51) Int Cl.:
**H02N 1/08** $^{(2006.01)}$ **B81B 3/00** $^{(2006.01)}$

(86) Numéro de dépôt international:
**PCT/EP2011/071194**

(87) Numéro de publication internationale:
**WO 2012/072586 (07.06.2012 Gazette 2012/23)**

(54) **DISPOSITIF DE CONVERSION D'ENERGIE MECANIQUE EN ENERGIE ELECTRIQUE**

VORRICHTUNG ZUR UMWANDLUNG VON MECHANISCHER SCHWINGUNGSENERGIE IN ELEKTRISCHE ENERGIE

DEVICE FOR CONVERTING MECHANICAL ENERGY INTO ELECTRICAL ENERGY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.11.2010 FR 1059842**

(43) Date de publication de la demande:
**09.10.2013 Bulletin 2013/41**

(73) Titulaire: **Commissariat à l'Énergie Atomique et aux Énergies Alternatives 75015 Paris (FR)**

(72) Inventeurs:
- BOISSEAU, Sébastien
  **F-38100 Grenoble (FR)**
- DESPESSE, Ghislain
  **F-38120 Saint Egreve (FR)**

(74) Mandataire: **Guérin, Jean-Philippe et al Opilex 310 avenue Berthelot 69008 Lyon (FR)**

(56) Documents cités:
**US-A1- 2004 007 877     US-A1- 2008 122 313
US-A1- 2008 258 565     US-A1- 2009 058 224
US-A1- 2009 079 295     US-A1- 2010 072 855**

- NARUSE Y ET AL: "Electrostatic micro power generation from low-frequency vibration such as human motion; Electrostatic micro power generation from low-frequency vibration", JOURNAL OF MICROMECHANICS & MICROENGINEERING, INSTITUTE OF PHYSICS PUBLISHING, BRISTOL, GB, vol. 19, no. 9, 1 septembre 2009 (2009-09-01), page 94002, XP020164961, ISSN: 0960-1317

**Description**

L'invention concerne les dispositifs de conversion d'énergie mécanique en énergie électrique, et en particulier les dispositifs d'alimentation autonome générant une énergie électrique à partir d'un mouvement vibratoire.

Dans certains environnements, il peut être délicat de connecter un circuit électrique à des câbles d'alimentation, par exemple dans des milieux hostiles ou sur des mécanismes en mouvement. Pour pallier ce problème, des dispositifs micromécaniques de conversion d'énergie vibratoire en énergie électrique sont connus. Ces dispositifs forment des microsystèmes généralement accolés sur des supports vibrants, tels que des machines ou des véhicules. Selon une technique connue, on utilise un système résonant pour amplifier une vibration mécanique d'un support et convertir le mouvement amplifié en électricité. Le circuit électrique peut ainsi être alimenté sans faire appel à des câbles provenant de l'extérieur.

Un des principes connus pour transformer de l'énergie mécanique vibratoire en énergie électrique est basé sur un système électrostatique. Le système électrostatique utilise une capacité variable pour convertir l'énergie mécanique vibratoire en énergie électrique.

Parmi ces systèmes électrostatiques, une première famille comporte des capacités dont les plaques sont polarisées par des sources d'alimentation électriques. Le principal problème rencontré avec cette première famille de systèmes électrostatiques porte sur la nécessité de disposer d'une source d'alimentation électrique disponible avant de réaliser une conversion d'énergie. Une telle source d'alimentation électrique complexifie la structure de gestion électrique du système électrostatique d'une part. D'autre part, une telle source d'alimentation consomme une partie de l'énergie générée, diminuant de ce fait le rendement global de la structure de conversion d'énergie.

Du fait de ces inconvénients, une deuxième famille de systèmes électrostatiques a été développée. De tels systèmes électrostatiques sont basés sur l'utilisation d'électrets. Un électret est un matériau diélectrique présentant un état de polarisation électrique quasi permanent. A la différence d'un condensateur classique dont la polarisation est transitoire (la charge stockée finit par disparaître d'elle-même), un électret peut conserver sa polarisation pendant une période de temps très importante (de l'ordre de plusieurs dizaines d'années). Pour réaliser un convertisseur mécanique/électrique électrostatique à base d'électrets, il suffit de disposer de deux électrodes en vis-à-vis et de créer un mouvement relatif entre un.électret et au moins une de ces deux électrodes. Le déplacement de l'électret induit une variation de charge électrique lorsque les électrodes se trouvent dans un circuit électrique fermé. Par conséquent, un circuit électrique fermé formé aux bornes des électrodes est traversé par un courant électrique lorsque le système est soumis à des vibrations.

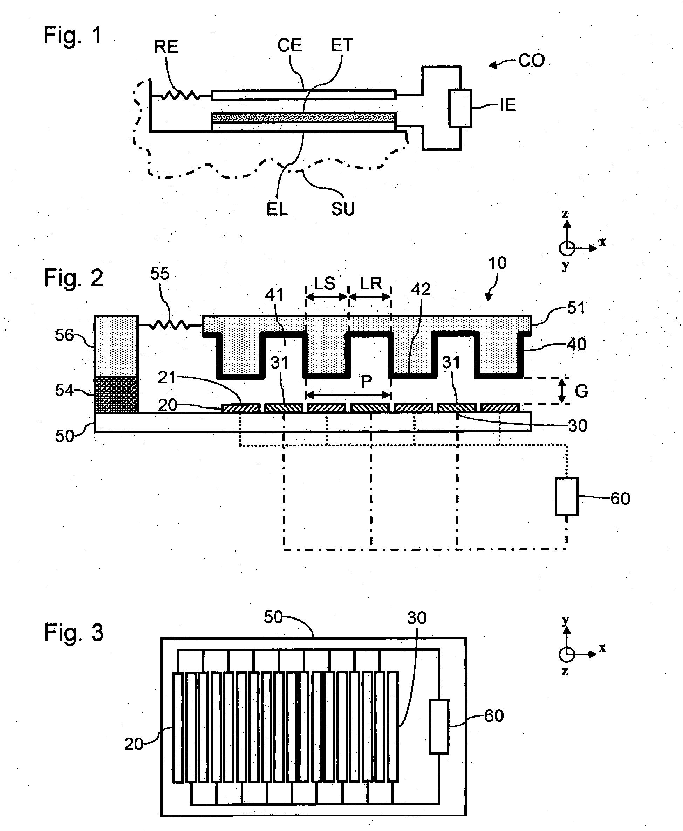

La figure 1 est une représentation schématique d'un exemple de convertisseur mécanique/électrique CO basé sur l'utilisation d'un électret. Comme illustré, le convertisseur CO comprend une électrode EL et une contre-électrode CE formées de plaques métalliques raccordées par une impédance électrique IE. Un électret ET formant une plaque est fixé sur l'électrode EL. L'électrode EL et l'électret ET sont solidaires d'un support SU. La contre électrode CE est montée mobile dans son plan par l'intermédiaire d'un ressort RE par rapport au support SU.

Grâce aux vibrations du milieu, la contre électrode se déplace et l'influence de l'électret sur cette électrode varie. Du fait de la loi de conservation des charges, la somme des charges de l'électrode et de la contre électrode est égale à la charge de l'électret qui est constante. Par conséquent, une redistribution des charges entre l'électrode et la contre électrode intervient. Les tensions/courants qui en découlent permettent ainsi d'alimenter l'impédance électrique.

Un électret en pleine plaque et d'une surface dépassant le centimètre carré peut stocker une charge relativement importante (quelques mC/m$^2$) avec une bonne stabilité (supérieure à 10 ans). La stabilité est définie par la durée de conservation des charges par l'électret.

Cependant, il s'avère qu'un tel convertisseur présente une variation de capacité réduite lorsqu'il est soumis à de faibles mouvements vibratoires. Ainsi, l'énergie électrique générée reste relativement réduite.

Afin d'accroître la variation de capacité entre deux électrets en vis-à-vis sous l'effet des vibrations, le document « Electrostatic micro power génération from low-frequency vibration such as human motion » propose un procédé de fabrication formant une alternance d'électrets et d'absence d'électrets selon une direction parallèle à une direction de coulissement. Ce document propose de former des électrets successifs avec un pas relativement réduit pour accroître la variation de capacité lors du mouvement vibratoire. Selon ce procédé, on forme une couche plane d'oxyde de silicium isolante sur un substrat en silicium. Une couche d'aluminium est déposée sur l'oxyde de silicium. Le motif des électrets à former est ensuite défini en gravant la couche d'aluminium. Des charges sont alors implantées de façon localisée dans la couche d'oxyde de silicium pour former les électrets. L'aluminium résiduel est ainsi utilisé comme un masque pour empêcher le chargement des zones qu'il recouvre.

Le substrat en silicium est monté coulissant sur une première plaque de verre par l'intermédiaire d'un ressort. Une deuxième plaque de verre supporte une alternance d'électrodes de polarités opposées. Une impédance électrique est connectée entre les électrodes de chaque polarité. Les plaques de verre sont fixes l'une par rapport à l'autre. Le support en silicium et ses électrets sont disposés entre les deux plaques de verre, en vis-à-vis des électrodes. Les électrodes d'une même polarité sont réparties avec un pas identique au pas de répartition des électrets.

On a cependant constaté que de tels électrets présentaient une stabilité insuffisante, en particulier pour des pas de répartition relativement réduits (<300 µm). Un tel manque de stabilité limite le développement d'un tel convertisseur, puisqu'une réduction du pas entre les électrets est destinée à améliorer le rendement de conversion lorsque la structure est soumise à de petites amplitudes de vibration.

Le document « HARVESTING ENERGY FROM VIBRATIONS BY A MICROMACHINED ELECTRET GENERATOR » rédigé par MM. Sterken, Fiorini, Altena, Van Hoof et Puers et publié à l'occasion de la 14e conférence internationale sur les capteurs solides tenue à Lyon du 10 au 14 juin 2007, décrit une structure destinée à bénéficier d'un électret présentant une grande stabilité. Cette structure est également structurée de façon à générer d'importantes variations de capacité lors du mouvement, ce qui doit en théorie induire un rendement de conversion amélioré. La structure comprend à cet effet une plaque de silicium fixée au-dessus d'un support de verre. Le support de verre supporte une première électrode comportant des motifs répartis selon un pas. Une masse mobile est ménagée dans la plaque de silicium et coulisse horizontalement au-dessus du support de verre. La masse mobile supporte une deuxième électrode comportant des motifs répartis selon un même pas. La deuxième électrode est disposée face à la première électrode. Un électret formé d'une couche continue de grandes dimensions polarise la deuxième électrode à travers la masse mobile de silicium.

En pratique, on ajoute une capacité constante, parasite, en série entre l'électret et la masse mobile, ce qui limite fortement le rendement de conversion de la structure.

Par ailleurs, l'ensemble des convertisseurs mécaniques/électrique à électrets développés jusqu'alors restent confinés à des prototypes de laboratoire sans réalisation industrielle.

L'invention vise à résoudre un ou plusieurs de ces inconvénients. L'invention porte ainsi sur un dispositif de conversion d'énergie mécanique vibratoire en énergie électrique tel que défini dans les revendications annexées.

L'invention porte également sur un procédé de fabrication d'un dispositif de conversion d'énergie mécanique en énergie électrique, tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :

- la figure 1 illustre schématiquement un exemple de convertisseur mécanique/électrique à électret ;
- la figure 2 est une vue en coupe d'une structure de conversion électrique/mécanique à électret selon un premier mode de réalisation de l'invention ;
- la figure 3 est une vue de dessus schématique de la configuration des électrodes de ce premier mode de réalisation ;
- la figure 4 est une vue en coupe d'une structure de conversion électrique/mécanique à électret selon un deuxième mode de réalisation de l'invention ;
- la figure 5 est une vue en coupe d'une structure de conversion électrique/mécanique à électret selon un troisième mode de réalisation de l'invention ;
- la figure 6 est une vue de dessous d'un exemple de combinaison de motifs d'électrets pour bénéficier d'une excitation vibratoire selon des axes distincts ;
- les figures 7a à 7e illustrent différentes étapes d'une première variante de procédé de fabrication d'un électret pour la réalisation d'une structure de conversion selon l'invention ;
- les figures 8a à 8g illustrent différentes étapes d'une deuxième variante de procédé de fabrication d'un électret pour la réalisation d'une structure de conversion selon l'invention ;
- la figure 9 est une vue en coupe de côté d'une structure de conversion électrique/mécanique à électret selon un quatrième mode de réalisation de l'invention;
- les figures 10 et 11 sont respectivement des vues de dessus et de dessous d'un couple d'électrodes et d'un électret de la structure de la figure 9 ;
- la figure 12 est une vue en coupe de côté d'une structure de conversion électrique/mécanique à électret selon un cinquième mode de réalisation de l'invention;
- les figures 13 et 14 sont respectivement des vues de dessus et de dessous d'un couple d'électrodes et d'un électret de la structure de la figure 12.

L'invention permet de bénéficier d'un électret présentant une très grande stabilité et permettant d'engendrer de fortes variations de capacité avec de petits déplacements. La quantité d'énergie électrique pouvant être générée à partir d'un dispositif de conversion d'une dimension donnée peut-être sensiblement accrue. Une variation de capacité importante par unité de déplacement relatif de l'electret peut-être obtenue de par la finesse autorisée de structuration de l'électret. Par ailleurs, cette finesse de structuration permet de s'adapter à une grande gamme d'amplitudes de vibration. Alors qu'un préjugé technique inciterait à la formation d'un électret discontinu en ne formant celui-ci que sur des saillies (la présence d'électret dans des rainures diminue en théorie la variation de capacité lors du déplacement d'une masse mobile), les inventeurs ont en fait établi qu'un électret avec des saillies formé en continu s'avérait particulièrement avantageux.

Les modes de réalisation illustrés en référence aux figures 2 à 6 portent sur des dispositifs de conversion d'énergie vibratoire dans lesquels un électret est monté coulissant par rapport à une électrode en vis-à-vis. L'électret coulisse dans un plan, et présente des saillies s'étendant perpendiculairement à ce plan.

La figure 2 est une vue en coupe d'un premier mode de réalisation d'une structure de conversion 10 d'énergie mécanique vibratoire en énergie électrique. La structure 10 comprend un support 50 destiné à être solidarisé au système générateur de l'énergie vibratoire. Une structure à base de silicium est fixée à l'aplomb du support 50 par l'intermédiaire d'une résine 54. La structure à base de silicium comprend un cadre fixe 56 et un support mobile 51. Le support mobile 51 est relié au cadre fixe 56 par l'intermédiaire d'un ressort 55. Le support mobile 51 est monté coulissant par rapport au support 50 selon la direction x. Le support 51 sollicite le ressort 55 lors de ses déplacements selon cet axe x. Le ressort 55 peut être réalisé par mise en forme de la structure à base de silicium.

Le support 50 est réalisé en matériau diélectrique, par exemple en verre. Le support 50 comporte une première électrode 20 et une deuxième électrode 30 sur sa surface supérieure. Les électrodes 20 et 30 sont formées de bandes métalliques se prolongeant selon la direction y. Les bandes métalliques formant l'électrode 20 comportent des faces 21 orientées vers le haut. Les bandes métalliques formant l'électrode 30 comportent des faces 31 orientées vers le haut. Les bandes métalliques de l'électrode 20 sont isolées des bandes métalliques de l'électrode 30. Les faces 21 sont réparties selon la direction x avec un pas P. Les faces 31 sont également réparties selon la direction x avec un pas P. Les faces 21 sont séparées les unes des autres par des faces 31. Les faces 21 et 31 sont donc alternées selon la direction x.

La figure 3 est une vue de dessus de la configuration des électrodes 20 et 30 sur le support 50. L'électrode 20 et l'électrode 30 sont connectées à des bornes respectives d'une charge électrique 60. La charge électrique 60 peut être un circuit électronique, incluant par exemple un circuit de recharge incluant une capacité de stockage d'énergie et un circuit fonctionnel alimenté par cette capacité. Les bandes métalliques formant l'électrode 20 sont connectées ensemble à une première borne de la charge électrique 60. Les bandes métalliques formant l'électrode 30 sont connectées à une deuxième borne de la charge électrique 60. Dans ce mode de réalisation, l'électrode 20, l'électrode 30 et la charge électrique 60 sont fixées sur un même support 50, ce qui facilite leur fabrication.

Un électret 40 est ménagé sur la face inférieure du support mobile 51. L'électret 40 comprend une couche continue de matériau diélectrique stockant des charges. La couche de diélectrique de l'électret 40 épouse le relief du support mobile 51 pour former une série de saillies 42 séparées par des rainures 41. L'électret 40 peut notamment comprendre une couche de $SiO_2$ ou une couche d'un polymère tel que le parylène. L'électret 40 est avantageusement formé d'une couche de matériau homogène. Les saillies 42 s'étendent selon la direction z. Les saillies 42 sont réparties selon la direction x avec un pas P identique au pas des bandes métalliques des électrodes 20 et 30. Les saillies 42 et les rainures 41 se prolongent selon la direction y. L'électret 40 est placé eh vis-à-vis des faces 21 et 31 respectivement des première et deuxième électrodes 20 et 30. Le support mobile 51 présente une course selon la direction x supérieure au pas P de répartition des saillies 42. L'ensemble formé du support mobile 51, de l'électret 40 et du ressort 55 présente une fréquence de résonance centrée sur une plage de fréquence de vibrations pour laquelle un gain de transformation optimal est recherché.

Lorsqu'une vibration sollicite le support mobile 51 et l'électret 40 selon la direction x (c'est-à-dire engendre un déplacement relatif entre le support 50 et le support 51), des transferts de charges électriques sont induits entre les électrodes 20 et 30. Du fait de ces transferts de charges, une différence de potentiel apparaît entre les bornes de la charge électrique 60 et cette charge électrique 60 est traversée par un courant électrique.

Lorsque le déplacement relatif de l'électret 40 est supérieur au pas P, plusieurs alternances électriques sont générées durant le parcours. En circuit électrique ouvert, la polarité de la différence de potentiel change lorsque l'électret coulisse d'une amplitude égale à la moitié du pas P. La quantité d'énergie électrique récupérée lorsque l'électret parcourt toute la course est ainsi maximisée. Par ailleurs, une conversion d'énergie électrique efficace est réalisée même lorsque l'amplitude du coulissement de l'électret 40 varie fortement dans le temps, plusieurs alternances pouvant être générées même avec un coulissement limité. La fréquence de la différence de potentiel générée aux bornes de la charge 60 peut-être supérieure à la fréquence de résonance du système résonant ou de la fréquence de vibration de la source de vibration. Ces performances sont obtenues tout en bénéficiant d'un électret 40 stable, du fait de l'utilisation d'une couche diélectrique continue.

L'invention s'avère particulièrement avantageuse lorsque l'électret présente un entrefer ou espace G entre l'électret 40 et l'électrode 20 relativement réduit, par exemple lorsque cet entrefer G est inférieur à 10 $\mu$m, voire inférieur à 5 $\mu$m. Les inventeurs ont en effet constaté que les effets de bord pouvaient être particulièrement sensibles pour de telles dimensions, favorisant par ailleurs le gain de conversion.

Pour limiter l'incidence de tels effets de bord, le pas P des saillies 42 est avantageusement au moins 20 fois supérieur à cet entrefer G. En désignant par LS la largeur des saillies 42 et par LR la largeur des rainures 41, il s'avère avantageux de respecter les relations :

LR>10*G

LS>10*G

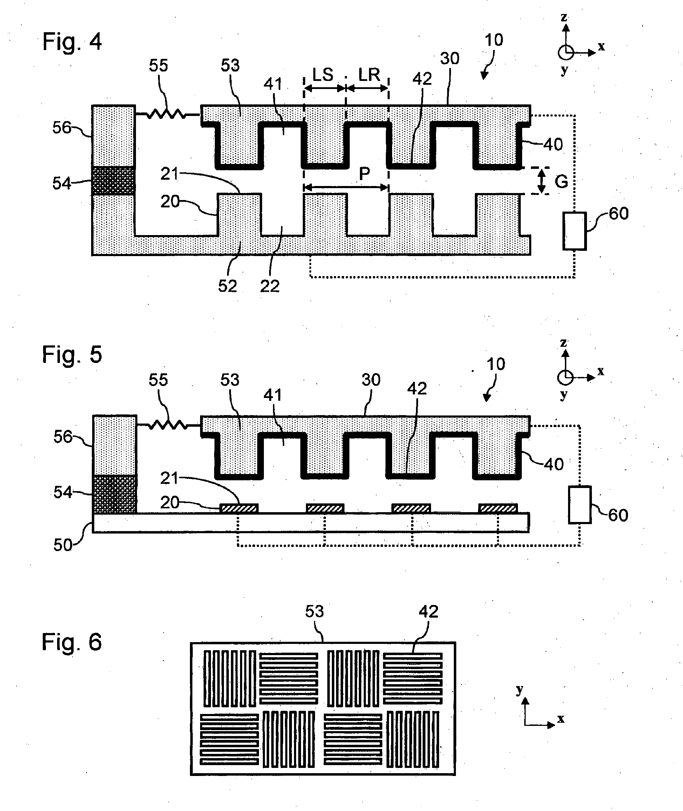

La figure 4 est une vue en coupe d'un deuxième mode de réalisation d'une structure de conversion 10 d'énergie mécanique vibratoire en énergie électrique. La structure 10 comprend un support 52 destiné à être solidarisé au système générateur de l'énergie vibratoire. Le support 52 est réalisé en matériau semi-conducteur, par exemple dans une plaque de Silicium.

Une structure à base de matériau semi-conducteur (plaque de Silicium) est fixée à l'aplomb du support 52 par l'intermédiaire d'une résine 54. La structure à base de silicium comprend un cadre fixe 56 et un support mobile 53. Le support mobile 53 est relié au cadre fixe 56 par l'intermédiaire d'un ressort 55. Le support mobile 53 est monté coulissant par rapport au support 52 selon la direction x. Le support 53 sollicite le ressort 55 lors de ses déplacements selon cet axe x. Le ressort 55 peut être réalisé par mise en forme d'une plaque de Silicium dans laquelle le cadre fixe 56 et le support mobile 53 sont formés.

Le support 53 comporte un relief selon la direction z, alternant des saillies et des rainures. Les saillies et les rainures du support 53 se prolongent selon la direction y. Les saillies et les rainures du support 53 sont réparties selon la direction x avec un pas P. Le support 52 comporte également un relief selon la direction z, alternant des rainures 22 et des saillies. Les saillies et les rainures du support 52 se prolongent selon la direction y. Les saillies et les rainures du support 52 sont réparties selon la direction x avec un pas P. Les reliefs des supports 52 et 53 sont disposés en vis-à-vis.

L'électret 40 comporte une couche continue recouvrant les saillies et les rainures du support 53. L'électret 40 peut notamment comprendre une couche de $SiO_2$ ou une couche d'un polymère tel que le parylène. L'électret 40 épouse le relief du support 53 et présente ainsi une alternance de saillies 42 et de rainures 41 réparties selon la direction x avec le pas P. Le pas P est inférieur à la course du support 53 et de l'électret 40 selon la direction x. Les saillies 42 et les rainures 41 se prolongent selon la direction y. L'électret 40 est avantageusement réalisé dans une couche de diélectrique d'épaisseur continue formée sur le support 53 en relief.

Le support 52 forme la première électrode 20 en présentant des faces 21 aux extrémités de ses saillies et en étant suffisamment conducteur pour conduire des charges électriques vers et depuis ces faces 21. Le support 53 forme la deuxième électrode 30 en étant suffisamment conducteur pour conduire les charges vers et depuis ses saillies. Les électrodes 20 et 30 sont ainsi formées dans des supports disposés de part et d'autre de l'électret 40. La charge électrique 60 est connectée entre le support 52 et le support 53.

Lorsque les saillies 42 sont en vis-à-vis des faces 21, la capacité formée est maximale et correspond à la somme des capacités C1 entre saillies 42 et faces 21 et des capacités C2 entre les rainures 41 et les rainures 22. La capacité Cmax formée s'exprime comme suit :

$$C_{max} = nC_1 + (n-1)C_2 = n\frac{\varepsilon_0 * LS * LO}{G + EP/\varepsilon} + (n-1)\frac{\varepsilon_0 * LS * LO}{2DE + G + EP/\varepsilon}$$

Avec n le nombre de saillies, EP l'épaisseur de l'électret, $\varepsilon$ la permittivité de l'électret, LO la longueur des saillies 42 et des faces 21, DE la profondeur des rainures 41 et des rainures 22, LS la largeur des saillies 42 et des faces 21.

Lorsque les saillies 42 sont en vis-à-vis des rainures 22, la capacité formée est minimale et correspond à la somme des capacités C3 entre saillies 42 et rainures 22 et des capacités C4 entre les rainures 41 et les faces 21. La capacité Cmin formée s'exprime comme suit :

$$C_{min} = nC_3 + (n-1)C_4 = (2n-1)\frac{\varepsilon_0 * LS * LO}{DE + G + EP/\varepsilon}$$

Pour une valeur de n élevée et pour DE≫G, le rapport entre Cmax et Cmin peut alors s'exprimer comme suit :

$$\frac{C_{max}}{C_{min}} \cong \frac{3}{4} + \frac{DS}{2\left(G + EP/\varepsilon\right)}$$

La structure proposée permet ainsi d'optimiser les variations de capacité par unité de déplacement durant le coulissement de l'électret 40 et d'augmenter le gain de transformation du convertisseur 10.

Afin de favoriser une variation de capacité optimale entre l'électret 40 et l'électrode 20 durant leur déplacement relatif, les rainures 41 séparant les saillies 42 de l'électret 40 présentent avantageusement une profondeur (relief selon la direction z) comprise entre 10 et 500μm.

Les inventeurs ont en outre constaté que l'utilisation d'une couche continue pour former l'électret 40 permettait de limiter les effets de bord pour des saillies 42 de petite dimension, par exemple lorsque leur pas P est inférieur à 200 μm, et en particulier lorsque leur pas P est inférieur à 100 μm.

Avantageusement, les rainures du support 53 sont plus larges que les saillies de ce même support 53. De même, les rainures du support 52 sont plus larges que les saillies de ce même support 52.

La figure 5 est une vue en coupe d'un troisième mode de réalisation d'une structure de conversion 10 d'énergie mécanique vibratoire en énergie électrique. La structure 10 comprend un support 50 destiné à être solidarisé au système générateur de l'énergie vibratoire. Le support 50 est réalisé en matériau isolant, par exemple dans une plaque de verre.

Une structure à base de matériau semi-conducteur (plaque de Silicium) est fixée à l'aplomb du support 50 par l'intermédiaire d'une résine 54. La structure à base de silicium comprend un cadre fixe 56 et un support mobile 53. Le support mobile 53 est relié au cadre fixe 56 par l'intermédiaire d'un ressort 55. Le support mobile 53 est monté coulissant par rapport au support 50 selon la direction x. Le support 53 sollicite le ressort 55 lors de ses déplacements selon cet axe x. Le ressort 55 peut être réalisé par mise en forme d'une plaque de Silicium dans laquelle le cadre fixe 56 et le support mobile 53 sont formés.

Le support 53 comporte un relief selon la direction z, alternant des saillies et des rainures. Les saillies et les rainures du support 53 se prolongent selon la direction y. Les saillies et les rainures du support 53 sont réparties selon la direction x avec un pas P.

Le support 50 comporte une face supérieure sensiblement plate sur laquelle une première électrode 20 est ménagée. L'électrode 20 est avantageusement ménagée en relief sur le support 50 afin d'accroître la variation de capacité durant le coulissement de l'électret 40. L'électrode 20 est formée de bandes métalliques s'étendant selon la direction y. Les bandes métalliques formant l'électrode 20 comportent des faces 21 orientées vers le haut. Les faces 21 sont réparties selon la direction x avec un pas P.

L'électret 40 comporte une couche continue recouvrant les saillies et les rainures du support 53. L'électret 40 peut notamment comprendre une couche de SiO$_2$ ou une couche d'un polymère tel que le parylène. L'électret 40 épouse le relief du support 53 et présente ainsi une alternance de saillies 42 et de rainures 41 réparties selon la direction x avec un pas P. Le pas P est inférieur à la course du support 53 et de l'électret 40 selon la direction x. Les saillies 42 et les rainures 41 se prolongent selon la direction y. L'électret 40 est avantageusement réalisé dans une couche de diélectrique d'épaisseur continue formée sur le support 53 en relief. L'électret 40 est en vis-à-vis de l'électrode 20.

Le support 53 forme la deuxième électrode 30 en étant suffisamment conducteur pour conduire les charges vers et depuis ses saillies. Les électrodes 20 et 30 sont ainsi formées sur des supports disposés de part et d'autre de l'électret 40. La charge électrique 60 est connectée entre l'électrode 20 et l'électrode 30.

Les électrodes 20 et 30 des supports 51, 52 et 53 des modes de réalisation détaillés auparavant peuvent également être formées par une couche conductrice épousant leur relief. L'électrode 30 ménagée sur un support 51 ou 53 peut par exemple être formée d'une couche conductrice métallique disposée entre le Silicium du support et l'électret 40.

La figure 6 est une vue de dessous d'un support 53 comportant deux groupes d'électrets 40. Les électrets d'un premier groupe présentent des saillies 42 réparties selon la direction y. Les électrets d'un second groupe présentent des saillies 42 réparties selon la direction x. Les électrets 40 sont à l'aplomb d'électrodes 20 et 30 présentant des répartitions correspondantes. Le support 53 est monté coulissant selon les directions x et y par rapport à l'électrode 20. Ainsi, le convertisseur 10 est capable d'exploiter de façon optimale des vibrations présentant différentes orientations ou présentant des orientations variables dans le temps.

On peut également prévoir différents électrets présentant des pas de répartition respectifs distincts. On peut en outre prévoir différents électrets, présentant des déphasages distincts par rapport aux électrodes 20 disposées en vis-à-vis.

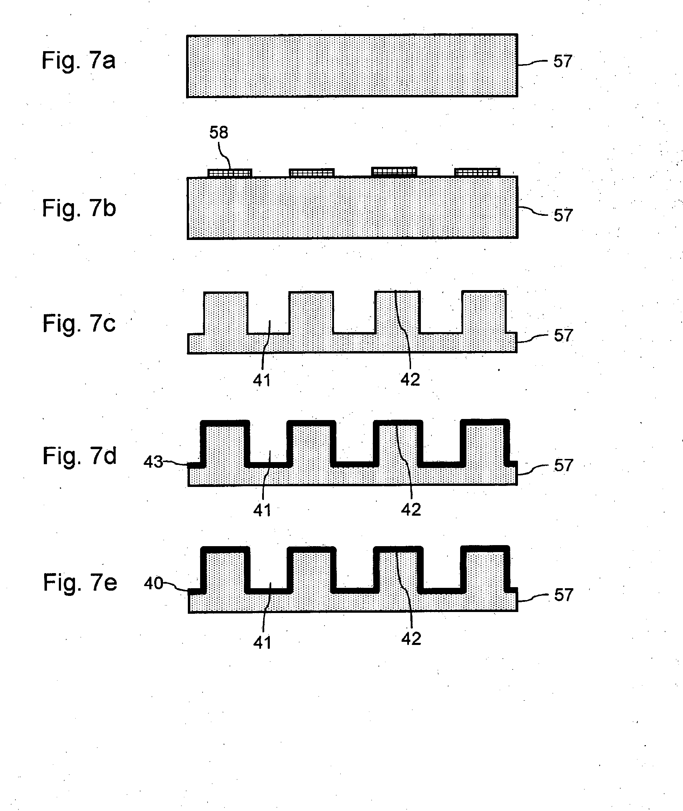

Les figures 7a à 7e illustrent de façon schématique une première variante d'un procédé de fabrication d'un électret 40 sur un support en silicium 57. Dans un souci de simplification, ce procédé ne décrit pas certaines étapes facultatives, telles que la formation d'un ressort de liaison du support ou l'assemblage de l'électret formé dans un dispositif de conversion.

À la figure 7a, on dispose d'une plaque de Silicium 57 présentant deux faces sensiblement plates.

Comme illustré à la figure 7b, on réalise ensuite un dépôt de résine. Par un processus de photolithographie connu en soi, on forme un motif 58 de résine durcie sur une face de la plaque de silicium.

Comme illustré à la figure 7c, on forme un relief dans la plaque de silicium 57 par une étape de gravure en utilisant le motif 58. Des procédés de gravure connus en soi de l'homme du métier peuvent être utilisés. On peut faire appel à des procédés par gravure humide (tels que la gravure KOH) ou faire appel à des procédés par gravure sèche (tels que la gravure DRIE). Dans le cadre de l'invention, on utilise avantageusement une gravure DRIE qui permet de réaliser des saillies avec des flancs très droits, même avec des profondeurs des rainures dépassant 100 µm. Après retrait de la résine, la gravure peut être suivie d'un traitement thermique. Les reliefs formés présentent ainsi une alternance dé saillies et de rainures ménagées dans la plaque de silicium 57.

Comme illustré à la figure 7d, un film 43 de matériau diélectrique est formé sur le relief de la plaque de silicium 57. Le film 43 présente en l'occurrence une épaisseur homogène et épouse le relief de la plaque 57. Le film 43 présente ainsi une alternance de saillies 42 et de rainures 41. Le film 43 est par exemple réalisé dans un matériau polymère tel que le parylène. Ce matériau favorise la stabilité de l'électret à former, puisqu'il est hydrophobe et limite ainsi la perte de charge due à l'humidité. Ce matériau présente en outre une bonne aptitude à stocker des charges électriques de façon permanente. Le film 43 peut par exemple présenter une épaisseur comprise entre 10nm et 9µm.

Comme illustré à la figure 7e, une charge est ensuite implantée dans le film 43 afin de former un électret 40 continu. L'implantation d'une charge pour former l'électret 40 peut être réalisée de toute manière appropriée. L'implantation des charges peut notamment être réalisée par la technique dite de décharge Corona. Une décharge Corona est une décharge électrique apparaissant lorsque le champ électrique dépasse une certaine valeur dans des conditions insuffisantes pour permettre la création d'un arc électrique. Le milieu entourant le conducteur électrique est alors ionisé et crée un plasma. Les ions créés transfèrent leurs charges aux molécules environnantes de plus basse énergie. L'implantation des charges sera avantageusement réalisée par un procédé de décharge Corona triode dans lequel une grille métallique est utilisée pour contrôler le potentiel de surface et homogénéiser la charge dans l'électret. L'étape de chargement pourra être suivie d'un traitement thermique.

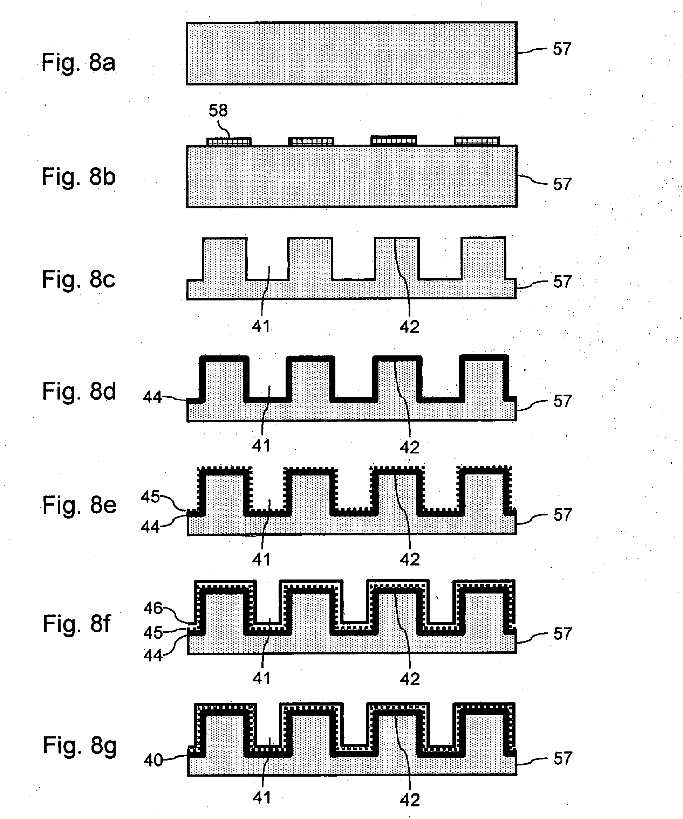

Les figures 8a à 8g illustrent de façon schématique une deuxième variante d'un procédé de fabrication d'un électret 40 sur un support en silicium 57.

À la figure 8a, on dispose d'une plaque de Silicium 57 présentant deux faces sensiblement plates.

Comme illustré à la figure 8b, on réalise ensuite un dépôt de résine. Par un processus de photolithographie connu en soi, on forme un motif 58 de résine durcie sur une face de la plaque de silicium 57.

Comme illustré à la figure 8c, on forme un relief dans la plaque de silicium 57 par une étape de gravure en utilisant le motif 58. Des procédés de gravure connus en soi de l'homme du métier peuvent être utilisés. Les reliefs formés présentent ainsi une alternance de saillies et de rainures ménagées dans la plaque de silicium 57. La résine est ensuite retirée.

Comme illustré à la figure 8d, une couche 44 de matériau diélectrique est formée sur le relief de la plaque de silicium 57. La couche 44 est une couche de $SiO_2$, créée par exemple par oxydation thermique de la face en relief de la plaque 57. La couche 44 présente ainsi une alternance de saillies 42 et de rainures 41. La couche 44 peut par exemple être formée avec une épaisseur comprise entre 50 nm et 5 µm.

Comme illustré à la figure 8e, une couche 45 d'un matériau stabilisant est avantageusement formée sur la couche 44. La couche 45 est par exemple réalisée en nitrure de silicium $Si_3N_4$. Une telle couche 45 permet d'améliorer la stabilité de l'électret formé en piégeant les charges. La couche 45 peut être réalisée par dépôt chimique en phase vapeur basse pression (LPCVD). La couche 45 peut par exemple présenter une épaisseur comprise entre 50 et 500 nm. Le dépôt de la couche 45 peut être suivi d'une étape de traitement thermique, typiquement à une température supérieure à 400°C pendant plusieurs heures.

Comme illustré à la figure 8f, une couche de protection 46 peut être déposée. La couche de protection 46 vise à éviter un contact entre de l'humidité et l'électret formé, afin d'éviter une dissémination des charges stockées dans le diélectrique. La couche de protection 46 peut typiquement être réalisée en parylène ou en HMDS, qui présentent de bonnes propriétés hydrophobes. La couche 46 peut par exemple présenter une épaisseur comprise entre 10nm et 10µm.

Comme illustré à la figure 8g, une charge est ensuite implantée dans le film 44 afin de former un électret 40 continu. L'implantation d'une charge pour former l'électret 40 peut être réalisée de toute manière appropriée. L'implantation des charges peut par exemple être réalisée par décharge Corona.

D'autres procédés de formation d'un électret continu peuvent bien entendu être envisagés. On peut notamment procéder au dépôt d'un matériau diélectrique par pulvérisation sur un support.

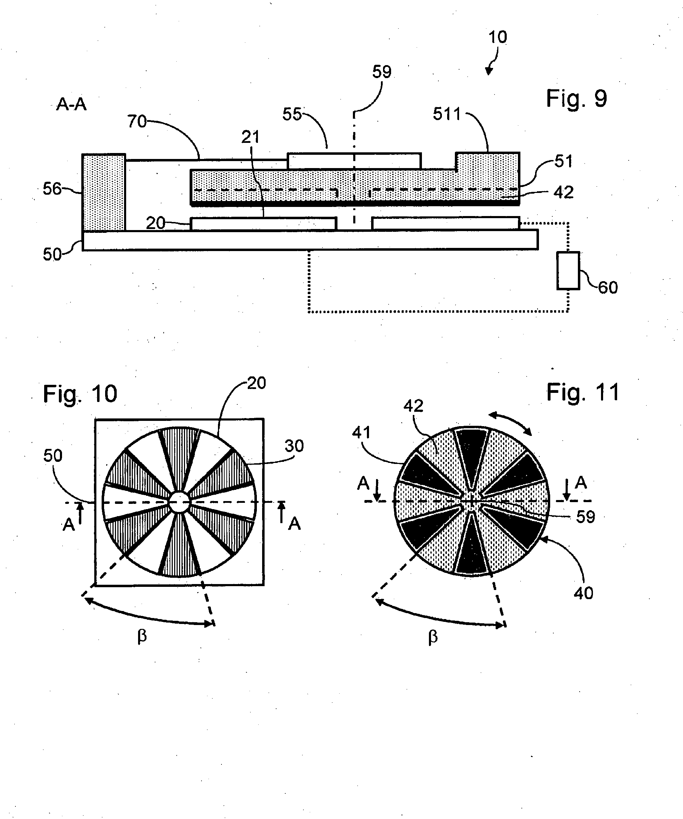

Les modes de réalisation illustrés en référence aux figures 9 à 14 portent sur des dispositifs de conversion d'énergie vibratoire dans lesquels un électret est monté pivotant par rapport à une électrode en vis-à-vis. L'électret pivote dans un plan, et présente des saillies s'étendant perpendiculairement à ce plan.

La figure 9 est une vue en coupe d'un quatrième mode de réalisation d'une structure de conversion d'énergie mécanique vibratoire en énergie électrique. La structure 10 comprend un support 50 destiné à être solidarisé au système générateur de l'énergie vibratoire. Une structure à base de silicium est fixée à l'aplomb du support 50. La structure à base de silicium comprend un cadre fixe 56 et un support mobile 51. Le support mobile 51 est relié au cadre fixe 56 par l'intermédiaire d'un ressort de torsion 55 et d'une poutre rigide 70. Le support mobile 51 est monté pivotant autour d'un axe vertical 59 (direction z) par rapport au cadre fixe 56. Une masse excentrée 511 est fixée sur le support mobile 51. La masse 511 est excentrée par rapport à l'axe 59. Du fait que l'ensemble formé par la masse 511 et le support mobile 51 est déséquilibré par rapport à l'axe 59, un mouvement relatif entre la masse mobile 51 et le support 50 génère une rotation de la masse mobile 51 par rapport au support 50. Le support 51 sollicite ainsi le ressort 55 lorsqu'il est soumis à une vibration, du fait de la présence de la masse excentrée 511.

La figure 10 est une vue de dessus du support 50 supportant des électrodes. La figure 11 est une vue de dessous du support 51 supportant un électret 40.

Le support 50 est réalisé en matériau diélectrique, par exemple en verre. Le support 50 comporte une première électrode 20 et une deuxième électrode 30 sur sa face supérieure. Les électrodes 20 et 30 sont formées de secteurs angulaires répartis autour d'un centre géométrique. Les secteurs angulaires formant l'électrode 20 comportent des faces 21 orientées vers le haut. Les secteurs angulaires formant l'électrode 30 comportent des faces également orientées vers le haut. Les secteurs angulaires de l'électrode 20 sont isolés des secteurs angulaires de l'électrode 30. Les faces 21 de l'électrode 20 sont réparties autour du centre géométrique avec un pas angulaire $\beta$. Les faces de l'électrode 30 sont réparties autour du centre géométrique avec un pas angulaire $\beta$. Les faces respectives des électrodes 20 et 30 sont alternées autour du centre géométrique. L'électrode 20 et l'électrode 30 sont connectées à des bornes respectives d'une charge électrique 60. Les secteurs angulaires formant l'électrode 20 sont connectés ensemble à une première borne de la charge électrique 60. Les secteurs angulaires formant l'électrode 30 sont connectés à une deuxième borne de la charge électrique 60. Dans ce mode de réalisation, l'électrode 20, l'électrode 30 et la charge électrique 60 sont fixées sur un même support 50, ce qui facilite leur fabrication.

L'électret 40 est ménagé sur la face inférieure du support mobile 51. L'électret 40 comprend une couche continue de matériau diélectrique stockant des charges. La couche de diélectrique de l'électret 40 épouse le relief du support mobile 51 pour former une série de saillies 42 en forme de secteurs angulaires, séparées par des rainures 41 en forme de secteurs angulaires. Les saillies 42 s'étendent selon la direction z par rapport à un plan dans lequel pivote le support 51. Les saillies 42 sont réparties autour de l'axe 59 avec un pas angulaire $\beta$ identique au pas angulaire des secteurs angulaires des électrodes 20 et 30. L'électret 40 est placé en vis-à-vis des faces des première et deuxième électrodes de 20 et 30. Le support mobile 51 présente une course de pivotement autour de l'axe 59 supérieure au pas angulaire $\beta$ de répartition des saillies 42. Lorsqu'une vibration sollicite le support mobile 51 avec une composante rotative autour de l'axe 59, le support mobile 51 pivote par rapport au support 50. Des transferts de charges électriques sont alors induits entre les électrodes 20 et 30. Du fait de ces transferts de charges, une différence de potentiel apparaît entre les bornes de la charge électrique 60 et cette charge électrique 60 est traversée par un courant électrique.

Lorsque le déplacement relatif de l'électret 40 est supérieur au pas angulaire $\beta$ entre les saillies 42, plusieurs alternances électriques sont générées durant le parcours. En circuit électrique ouvert, la polarité de la différence de potentiel change lorsque l'électret coulisse d'une amplitude égale à la moitié du pas angulaire $\beta$ entre les saillies 42. La quantité d'énergie électrique récupérée lorsque l'électret parcourt toute la course est ainsi maximisée.

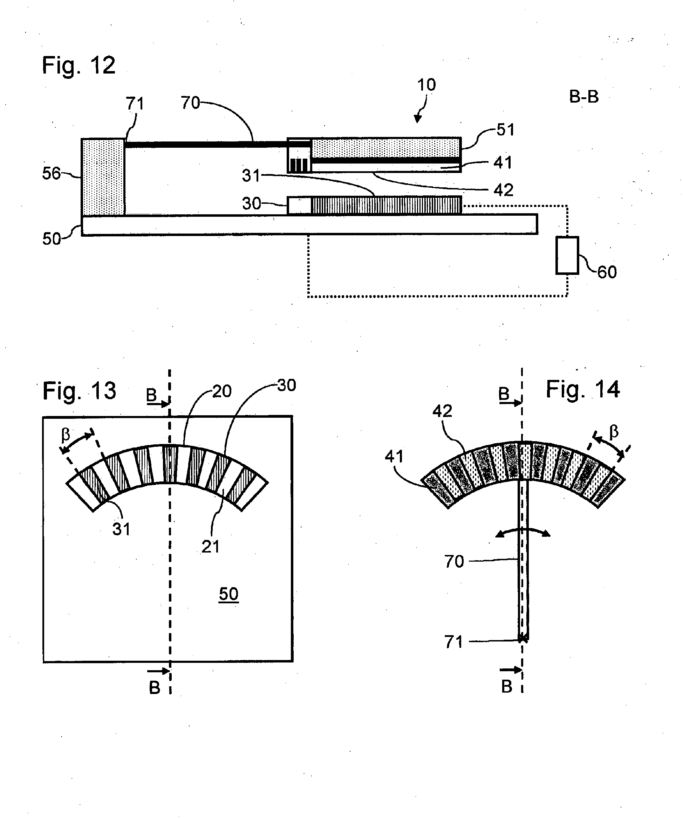

La figure 12 est une vue en coupe d'un cinquième mode de réalisation d'une structure de conversion d'énergie mécanique vibratoire en énergie électrique. La structure 10 comprend un support 50 destiné à être solidarisé au système générateur de l'énergie vibratoire. Une structure à base de silicium est fixée à l'aplomb du support 50. La structure à base de silicium comprend un cadre fixe 56 et un support mobile 51. Le support mobile 51 est relié au cadre fixe 56 par l'intermédiaire d'une poutre 70. La poutre 70 présente une extrémité encastrée dans le cadre fixe 56 et une autre extrémité encastrée dans le support 51. La poutre 70 est dimensionnée pour fléchir autour d'un axe vertical (de direction z) lorsqu'elle est soumise à des vibrations, sous l'effet de l'inertie du support mobile 51. Le support mobile 51 pivote alors au niveau d'un axe vertical passant par le point de jonction 71 entre la poutre 70 et le cadre fixe 56.

La figure 13 est une vue de dessus du support 50 supportant des électrodes. La figure 14 est une vue de dessous du support 51 supportant un électret 40.

Le support 50 est réalisé en matériau diélectrique. Le support 50 comporte une première électrode 20 et une deuxième électrode 30 sur sa face supérieure. Les électrodes 20 et 30 sont formées de secteurs angulaires d'un anneau, présentant le point de jonction 71 comme centre géométrique. Le centre géométrique est disposé sensiblement au niveau de l'axe de pivotement du support mobile 51. Les secteurs angulaires formant l'électrode 20 comportent des faces 21 orientées vers le haut. Les secteurs angulaires formant l'électrode 30 comportent des faces 31 également orientées vers le haut. Les secteurs angulaires de l'électrode 20 sont isolés des secteurs angulaires de l'électrode 30. Les faces 21 de l'électrode 20 sont réparties avec un pas angulaire $\beta$ sur un arc de cercle ayant le point de jonction 71 comme centre géométrique. Les faces 31 de l'électrode 30 sont réparties avec un pas angulaire $\beta$ sur un arc de cercle ayant le point de jonction 71 comme centre géométrique. Les faces respectives des électrodes 20 et 30 sont alternées autour du centre géométrique. L'électrode 20 et l'électrode 30 sont connectées à des bornes respectives d'une charge électrique 60. Les secteurs angulaires formant l'électrode 20 sont connectés ensemble à une première borne de la charge électrique 60. Les secteurs angulaires formant l'électrode 30 sont connectés à une deuxième borne de la charge électrique 60. Dans ce mode de réalisation, l'électrode 20, l'électrode 30 et la charge électrique 60 sont fixées sur un même support 50, ce qui facilite leur fabrication.

L'électret 40 est ménagé sur la face inférieure du support mobile 51. L'électret 40 comprend une couche continue de matériau diélectrique stockant des charges. La couche de diélectrique de l'électret 40 épouse le relief du support mobile 51 pour former une série de saillies 42 en forme de secteurs angulaires d'un anneau, séparées par des rainures 41 en forme de secteurs angulaires d'un anneau. Les saillies 42 s'étendent selon la direction z par rapport à un plan dans lequel pivote le support 51. Les saillies 42 sont réparties sur un arc de cercle ayant le point de jonction 71 comme centre géométrique avec un pas angulaire β identique au pas angulaire des secteurs angulaires des électrodes 20 et 30. L'électret 40 est placé en vis-à-vis des faces des première et deuxième électrodes de 20 et 30. Le support mobile 51 présente une course de pivotement autour du point de jonction supérieure au pas angulaire de répartition des saillies 42. Lorsqu'une vibration sollicite le support mobile 51 avec une composante rotative autour du point de jonction 71, le support mobile 51 pivote par rapport au support 50. Des transferts de charges électriques sont alors induits entre les électrodes 20 et 30. Du fait de ces transferts de charges, une différence de potentiel apparaît entre les bornes de la charge électrique 60 et cette charge électrique 60 est traversée par un courant électrique.

Lorsque le déplacement relatif de l'électret 40 est supérieur au pas angulaire β entre les saillies 42, plusieurs alternances électriques sont générées durant le parcours. En circuit électrique ouvert, la polarité de la différence de potentiel change lorsque l'électret coulisse d'une amplitude égale à la moitié du pas angulaire β entre les saillies 42. La quantité d'énergie électrique récupérée lorsque l'électret parcourt toute la course est ainsi maximisée.

**Revendications**

1.  Dispositif de conversion d'énergie mécanique vibratoire en énergie électrique (10), comprenant :

    - des première (20) et deuxième (30) électrodes collectrices destinées à être connectées aux bornes d'une charge électrique (60) ;
    - un électret (40) placé en vis-à-vis d'au moins la première électrode (20), monté mobile au moins par rapport à la première électrode (20) selon au moins un degré de liberté dans un plan, de sorte qu'un mouvement relatif entre l'électret et la première électrode induise une différence de potentiel entre les première et deuxième électrodes ;

    **caractérisé en ce que** :

    - l'électret (40) comporte une couche continue de diélectrique stockant des charges et présentant une série de saillies (42) s'étendant selon une dilection (z) perpendiculaire audit plan, les saillies étant réparties selon ledit degré de liberté avec un pas (P) inférieur à la course entre la première électrode et l'électret ;
    - la première électrode (20) présente des faces (21) en vis-à-vis de l'électret, ces faces étant réparties selon ledit degré de liberté avec un pas identique au pas des saillies de l'électret.

2.  Dispositif de conversion d'énergie (10) selon la revendication 1, dans lequel les première et deuxième électrodes (20,30) sont ménagées sur un même support (50) en vis-à-vis de l'électret (40), la deuxième électrode (30) présentant des faces réparties selon ledit degré de liberté avec un pas identique au pas des saillies (42) de l'électret, les faces (21,31) des première et deuxième électrodes étant alternées.

3.  Dispositif de conversion d'énergie selon la revendication 1, dans lequel les première et deuxième électrodes (20,30) sont ménagées sur des supports respectifs (52,53) disposés de part et d'autre de l'électret.

4.  Dispositif de conversion d'énergie selon l'une quelconque des revendications précédentes, dans lequel l'électret (40) est monté coulissant par rapport à la première électrode selon une direction incluse dans ledit plan, les saillies étant réparties dans ledit plan selon cette direction de côulissement, les faces de la première électrode étant réparties selon cette direction de coulissement.

5.  Dispositif de conversion d'énergie selon la revendication 4, dans lequel les faces (21) de la première électrode sont séparées par des rainures (22) présentant une largeur supérieure à la largeur des faces.

6.  Dispositif de conversion d'énergie selon la revendication 4 ou 5, dans lequel le pas (P) des saillies (42) est inférieur à 200 μm, de préférence inférieur à 100 μm.

7.  Dispositif de conversion d'énergie selon l'une quelconque des revendications 1 à 3, dans lequel l'électret (40) est monté pivotant par rapport à la première électrode autour d'un axe normal audit plan, les saillies étant réparties angulairement autour de cet axe, les faces de la première électrode étant réparties angulairement autour de cet axe.

8.  Dispositif de conversion d'énergie selon l'une quelconque des revendications précédentes, dans lequel les saillies (42) de l'électret sont séparées par des rainures (41) présentant une profondeur comprise entre 10 $\mu$m et 500 $\mu$m.

9. Dispositif de conversion d'énergie selon l'une quelconque des revendications précédentes, dans lequel l'électret (40) est séparé de la première électrode (20) par un espace (G) inférieur à 10 $\mu$m, de préférence inférieur à 5 $\mu$m.

10. Dispositif de conversion d'énergie selon la revendication 4 et 9, dans lequel le pas (P) des saillies (42) de l'électret (40) est au moins 20 fois supérieur audit espace.

11. Dispositif de conversion d'énergie selon l'une quelconque des revendications précédentes, dans lequel l'électret (40) est ménagé sur un support (51,53) en relief, l'électret étant formé d'une couche de diélectrique d'épaisseur continue.

12. Dispositif de conversion d'énergie selon l'une quelconque des revendications précédentes, dans lequel l'électret est recouvert d'une couche de protection (46) continue.

13. Dispositif de conversion d'énergie selon l'une quelconque des revendications précédentes, dans lequel l'électret est formé d'une couche d'oxyde de Silicium (44) ménagée sur un substrat (57) de silicium.

14. Dispositif de conversion d'énergie selon l'une quelconque des revendications précédentes, dans lequel l'électret est relié à la première électrode par l'intermédiaire d'un ressort (55) sollicité par un mouvement relatif selon ledit degré de liberté entre la première électrode (20) et l'électret (40).

15. Procédé de fabrication d'un dispositif de conversion d'énergie mécanique vibratoire en énergie électrique selon la revendication 1; comprenant les étapes de :

- formation d'une souche continue de diélectrique présentant une série de saillies s'étendant selon une direction et réparties avec un pas ;
- chargement de la couche continue de diélectrique formée de façon à former un électret ;
- assemblage de l'électret en vis-à-vis de première et deuxième électrodes collectrices, l'électret étant monté mobile par rapport à la première électrode selon un degré de liberté dans un plan perpendiculaire à ladite direction avec une course selon ce degré de liberté supérieure au pas des saillies, de sorte qu'un mouvement relatif entre l'électret et la première électrode induise une différence de potentiel entre les première et deuxième électrodes, la première électrode présentant des faces en vis-à-vis de l'électret réparties selon ledit degré de liberté avec un pas identique au pas des saillies de l'électret.

16. Procédé de fabrication selon la revendication 15, dans lequel la formation de la couche continue de diélectrique comprend :

- la gravure d'une face d'un support en Silicium pour former des saillies avec ledit pas selon une direction de coulissement relative entre l'électret et la première électrode ;
- la formation d'une couche continue de diélectrique sur la face gravée du support.

17. Procédé de fabrication selon la revendication 16, dans laquelle la formation de la couche continue de diélectrique est obtenue par oxydation de la face gravée du support en oxyde de Silicium.

**Patentansprüche**

1. Vorrichtung zur Umwandlung mechanischer Vibrationsenergie in elektrische Energie (10), welche umfasst:

- erste (20) und zweite (30) Niederschlagselektroden, die dazu ausgebildet sind, mit den Anschlüssen einer elektrischen Ladung (60) verbunden zu werden;
- ein Elektret (40), das gegenüber wenigstens der ersten Elektrode (20) platziert ist, wenigstens bezüglich der ersten Elektrode (20) gemäß wenigstens einem Freiheitsgrad in einer Ebene beweglich angebracht ist, so dass eine Relativbewegung zwischen dem Elektret und der ersten Elektrode eine Potenzialdifferenz zwischen der ersten und der zweiten Elektrode induziert;

**dadurch gekennzeichnet, dass**:

- das Elektret (40) eine fortlaufende dielektrische Schicht umfasst, die Ladungen speichert und eine Reihe von Vorsprüngen (42) aufweist, die sich in einer zur Ebene orthogonalen Richtung (z) erstrecken, wobei die Vorsprünge gemäß dem Freiheitsgrad mit einem Abstand (P) verteilt sind, der kleiner ist als der Weg zwischen der ersten Elektrode und dem Elektret;
- die erste Elektrode (20) Seiten (21) gegenüber dem Elektret aufweist, wobei diese Seiten gemäß dem Freiheitsgrad mit einem Abstand verteilt sind, der dem Abstand der Vorsprünge des Elektrets entspricht.

2. Vorrichtung zur Energieumwandlung (10) nach Anspruch 1, wobei die ersten und die zweiten Elektroden (20,30) auf einem gleichen Träger (50) gegenüber dem Elektret (40) angebracht sind, wobei die zweite Elektrode (30) Seiten aufweist, die gemäß dem Freiheitsgrad mit einem Abstand verteilt sind, der dem Abstand der Vorsprünge (42) des Elektrets entspricht, wobei die Seiten (21,31) der ersten und zweiten Elektroden abgewechselt sind.

3. Vorrichtung zur Energieumwandlung nach Anspruch 1, wobei die ersten und die zweiten Elektroden (20,30) auf jeweiligen Trägern (52,53) angebracht sind, die auf beiden Seiten des Elektrets angeordnet sind.

4. Vorrichtung zur Energieumwandlung nach einem der vorangehenden Ansprüche, wobei das Elektret (40) bezüglich der ersten Elektrode in einer in der Ebene eingeschlossenen Richtung verschiebbar angebracht ist, wobei die Vorsprünge in der Ebene gemäß dieser Verschieberichtung verteilt sind, wobei die Seiten der ersten Elektrode gemäß dieser Verschieberichtung verteilt sind.

5. Vorrichtung zur Energieumwandlung nach Anspruch 4, wobei die Seiten (21) der ersten Elektrode durch Nute (22) getrennt sind, die eine größere Größe aufweisen als die Größe der Seiten.

6. Vorrichtung zur Energieumwandlung nach Anspruch 4 oder 5, wobei der Abstand (P) der Vorsprünge (42) kleiner als 200 $\mu$m, vorzugsweise kleiner als 100 $\mu$m ist.

7. Vorrichtung zur Energieumwandlung nach einem der Ansprüche 1 bis 3, wobei das Elektret (40) bezüglich der ersten Elektrode um eine zur Ebene senkrechte Achse schwenkbar angebracht ist, wobei die Vorsprünge um diese Achse herum winklig verteilt sind, wobei die Seiten der ersten Elektrode um diese Achse herum winklig verteilt sind.

8. Vorrichtung zur Energieumwandlung nach einem der vorangehenden Ansprüche, wobei die Vorsprünge (42) des Elektrets durch Nute (41) getrennt sind, die eine Tiefe zwischen 10$\mu$m und 500 $\mu$m aufweisen.

9. Vorrichtung zur Energieumwandlung nach einem der vorangehenden Ansprüche, wobei das Elektret (40) von der ersten Elektrode (20) durch einen Raum (G) getrennt ist, der kleiner als 10 $\mu$m, vorzugsweise kleiner als 5 $\mu$m ist.

10. Vorrichtung zur Energieumwandlung nach Anspruch 4 und 9, wobei der Abstand (P) der Vorsprünge (42) des Elektrets (40) wenigstens 20-mal größer als der genannte Raum ist.

11. Vorrichtung zur Energieumwandlung nach einem der vorangehenden Ansprüche, wobei das Elektret (40) auf einem Träger (51,53) mit einer Struktur angebracht ist, wobei das Elektret aus einer dielektrischen Schicht mit fortlaufender Dicke gebildet ist.

12. Vorrichtung zur Energieumwandlung nach einem der vorangehenden Ansprüche, wobei das Elektret von einer fortlaufenden Schutzschicht (46) bedeckt ist.

13. Vorrichtung zur Energieumwandlung nach einem der vorangehenden Ansprüche, wobei das Elektret aus einer auf einem Siliziumsubstrat (57) angebrachten Siliziumoxidschicht (44) gebildet ist.

14. Vorrichtung zur Energieumwandlung nach einem der vorangehenden Ansprüche, wobei das Elektret mit der ersten Elektrode mittels einer Feder (55) verbunden ist, beaufschlagt durch eine Relativbewegung gemäß dem Freiheitsgrad zwischen der ersten Elektrode (20) und dem Elektret (40).

15. Verfahren zur Herstellung einer Vorrichtung zur Umwandlung mechanischer Energie in elektrische Energie, welches folgende Schritte umfasst:

- Bildung einer fortlaufenden dielektrischen Schicht, welche eine Reihe von Vorsprüngen aufweist, die sich in einer Richtung erstrecken und mit einem Abstand verteilt sind;

- Ladung der zur Bildung eines Elektrets gebildeten fortlaufenden dielektrischen Schicht;
- Anordnen des Elektrets gegenüber von ersten und zweiten Niederschlagselektroden, wobei das Elektret bezüglich der ersten Elektrode beweglich angebracht ist gemäß einem Freiheitsgrad in einer Ebene orthogonal zur genannten Richtung mit einem Weg gemäß diesem Freiheitsgrad, der größer ist als der Abstand der Vorsprünge, so dass eine Relativbewegung zwischen dem Elektret und der ersten Elektrode eine Potenzialdifferenz zwischen der ersten und der zweiten Elektrode induziert, wobei die erste Elektrode Seiten gegenüber dem Elektret aufweist, die gemäß dem Freiheitsgrad mit einem Abstand verteilt sind, der dem Abstand der Vorsprünge des Elektrets entspricht.

16. Herstellungsverfahren nach Anspruch 15, bei welchem die Bildung der fortlaufenden dielektrischen Schicht umfasst:

- Gravur einer Seite eines Siliziumträgers zur Bildung von Vorsprüngen mit dem Abstand gemäß einer relativen Verschieberichtung zwischen dem Elektret und der ersten Elektrode;
- Bildung einer fortlaufenden dielektrischen Schicht auf der gravierten Seite des Trägers.

17. Herstellungsverfahren nach Anspruch 16, wobei die Bildung der fortlaufenden dielektrischen Schicht durch Oxidation der gravierten Seite des Siliziumoxidträgers erzielt wird.

## Claims

1. An apparatus for converting mechanical vibrational energy into electrical power (10), comprising:

- first (20) and second (30) collecting electrodes intended for connection to terminals of an electrical charge (60);
- an electret (40) placed opposite at least the first electrode (20), being assembled so as to be mobile at least in relation to the first electrode (20) along at least one degree of freedom in a plane, so that a relative movement between the electret and the first electrode induces a difference in potential between the first and second electrodes;

**characterised in that**:

- the electret (40) includes a continuous layer of dielectric storing charges and having a series of protrusions (42) extending in a direction (z) perpendicular to the said plane, the said protrusions being distributed along the said degree of freedom with a pitch (P) that is smaller than the extent of travel between the first electrode and the electret;
- the first electrode (20) has faces (21) that are opposite the electret, the said faces being distributed along the said degree of freedom with a pitch identical to the pitch of the protrusions from the electret.

2. An energy conversion apparatus (10) according to claim 1, in which the first and second electrodes (20, 30) are housed on a common support (50) opposite the electret (40), the second electrode (30) having faces distributed along the said degree of freedom with a pitch identical to the pitch of the protrusions (42) of the electret, the faces (21, 31) of the first and second electrodes being alternated.

3. An energy conversion apparatus according to claim 1, in which the first and second electrodes (20, 30) are housed on respective supports (52, 53) arranged on either side of the electret.

4. An energy conversion apparatus according to any of the previous claims, in which the electret (40) is assembled so as to slide in relation to the first electrode in a direction within the said plane, the protrusions being distributed within the said plane in that sliding direction, the faces of the first electrode being distributed in the said sliding direction.

5. An energy conversion apparatus according to claim 4, in which the faces (21) of the first electrode are separated by grooves (22) having a width greater than the width of the faces.

6. An energy conversion apparatus according to claims 4 or 5, wherein the said pitch (P) of the protrusions (42) is less than 200 μm, and preferably less than 100 μm.

7. An energy conversion apparatus according to any of claims 1 to 3, in which the electret (40) is assembled to as to pivot in relation to the first electrode about an axis normal to the said plane, the protrusions being distributed angularly about the said axis, said faces of said first electrode being distributed angularly about the said axis.

8. An energy conversion apparatus according to any of the previous claims, in which the protrusions (42) of the electret are separated by grooves (41) that have a depth of between 10μm and 500 μm.

9. An energy conversion apparatus according to any of the previous claims, in which the electret (40) is separated from the first electrode (20) by a space (G) that is less than 10 μm, and preferably less than 5 μm.

10. An energy conversion apparatus according to claims 4 and 9, in which the pitch (P) of the protrusions (42) of the electret (40) is at least 20 times greater than the said space.

11. An energy conversion apparatus according to any of the previous claims, in which the electret (40) is housed on a raised support (51, 53), the electret being formed of a layer of dielectric of continuous thickness.

12. An energy conversion apparatus according to any of the previous claims, in which the electret is covered by a continuous protective layer (46).

13. An energy conversion apparatus according to any of the previous claims, in which the electret is formed of a layer of silicon oxide (44) housed on a silicon substrate (57).

14. An energy conversion apparatus according to any of the previous claims, in which the electret is connected to the first electrode by means of a spring (55) placed under stress by a relative movement along the said degree of freedom between the first electrode (20) and the electret (40).

15. A process for manufacturing an apparatus for the conversion of mechanical energy into electrical power, including the following phases:

  - The formation of a continuous dielectric layer having a series of protrusions extending in one direction and distributed with a pitch;
  - The charging of a continuous dielectric layer shaped so as to form an electret;
  - The assembly of the electret so as to face first and second collecting electrodes, the said electret being assembled so as to be mobile in relation to the first electrode along a degree of freedom within a plane perpendicular to the said direction with travel along this degree of freedom being greater than the pitch of the protrusions, whereby a relative movement between the electret and the first electrode induces a difference in potential between the first and second electrodes, the first electrode having faces opposite the electret distributed along the said degree of freedom with a pitch identical to the pitch of the protrusions of the electret.

16. A manufacturing process according to claim 15 in which the formation of the continuous dielectric layer includes:

  - The etching of one face of a silicon support in order to form protrusions with the said pitch in a relative sliding direction between the electret and the first electrode;
  - The formation of a continuous dielectric layer on the etched face of the support.

17. A manufacturing process according to claim 16 in which the formation of the continuous dielectric layer is achieved through oxidation of the etched face of the silicon oxide support.

Fig. 1

Fig. 2

Fig. 3

Fig. 4

Fig. 5

Fig. 6

Fig. 7a

57

Fig. 7b

58

57

Fig. 7c

57

41    42

Fig. 7d

43

57

41    42

Fig. 7e

40

57

41    42

Fig. 8a

Fig. 8b

Fig. 8c

Fig. 8d

Fig. 8e

Fig. 8f

Fig. 8g

10

59

A-A

70    55    511

Fig. 9

21

56    20

50    42    51

60

Fig. 10

20

30

50

A    A

β

Fig. 11

42

41

A    A

59

40

β

## Fig. 12

B-B

## Fig. 13

## Fig. 14

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **MM. STERKEN ; FIORINI ; ALTENA ; VAN HOOF ; PUERS.** HARVESTING ENERGY FROM VIBRATIONS BY A MICROMACHINED ELECTRET GENERATOR. *14e conférence internationale sur les capteurs solides tenue à Lyon,* 10 Juin 2007